# EUROPEAN PATENT APPLICATION

(11) **EP 3 057 111 A1**
(43) Date of publication of application: **17.08.2016**
(21) Application number: 15155079.5
(22) Date of filing: 13.02.2015
(51) Int. Cl.: H01F 27/14, E21B 33/038, H05K 5/06

(54) **PRESSURE COMPENSATOR AND METHOD OF MANUFACTURING A PRESSURE COMPENSATOR**

(71) Applicant: Siemens Aktiengesellschaft, 80333 München (DE)
(72) Inventor: Klingsheim, Livar, 4051 Sola (NO)

(57) **Abstract**

A pressure compensator for providing pressure compensation for a subsea device is provided. The pressure compensator has a compensator wall enclosing a compensation chamber and at least one bellows assembly. The bellows assembly includes a metal bellows that forms part of the compensator wall. The metal bellows is deformable to change the inner volume of the compensation chamber. The bellows assembly further includes an elastomeric bellows provided on the compensator wall and covering at least the metal bellows. A seal seals the space between the metal bellows and the elastomeric bellows. The space between the metal bellows and the elastomeric bellows is provided with a vacuum.

## Description

### Field of the invention

The present invention relates to a pressure compensator for providing pressure compensation for subsea device, and to a method of manufacturing a pressure compensator.

### Background

Traditionally, fixed or floating platforms, or floating production vessels, are used in the offshore oil and gas production. In the operation of offshore platforms, it can be necessary to install electrical equipment under water, e.g. for controlling functions of a subsea Christmas tree or a subsea blowout preventer. More recently, processing facilities are being relocated to the ocean floor. Installations on the ocean floor can comprise a range of components, including pumps, compressors and the like which require electric power for operation. Power supply can occur through a subsea power grid installed on the ocean floor, which may for example comprise a subsea transformer, a subsea switchgear and a subsea variable speed drive for powering the above mentioned subsea loads. It needs to be ensured that the installed equipment operates reliably even under the high pressure that prevails at the rated installation depth, which can be 3.000 m or more.

To protect the equipment from the corrosive environment of the surrounding seawater and to deal with the high pressures, two different solutions were proposed. A pressure resistant enclosure can be provided, which has a close to atmospheric internal pressure, enabling the use of conventional electric and electronic components therein. Such enclosures need to have relatively thick walls and are thus bulky and heavy, since they have to withstand high differential pressures.

Another solution is the use of pressurized (or pressure compensated) enclosures, which employ a pressure compensator that balances the pressure in the enclosure to the pressure prevailing in the ambient seawater.

The pressurized enclosure is generally filled with a liquid, and components operated inside the pressurized enclosure are made to be operable under high pressures. The pressure compensator balances the pressure and compensates variations in the volume of the liquid filling the enclosure, which may for example occur due to variations in outside pressure and/or temperature. Temperature changes can also be caused by internal heating, e.g. by electric losses of components provided inside the enclosure of the subsea device. The corresponding volume increase of the liquid filling the enclosure may then be taken up by the pressure compensator, which is thus also termed volume compensator.

Pressure compensators may include bellows, bladders, pistons, membranes or the like. Bellows can have the disadvantage that they are either expensive to produce, or their configuration is such that the stroke length of the bellows is limited. In the latter case, a pressure compensator for a large volume of liquid (i.e. for an enclosure of a large subsea device) needs to have a significant size to provide the required compensation capacity. For some types of bellows, the bellows needs to have a size of more than three times of the size of the compensated volume. This results in a low utilization factor of the volume of the compensator system. Furthermore, the liquid filling such pressure compensator needs to be compensated itself (i.e. changes of its volume due to temperature/pressure changes need to be taken up by the compensator). Such compensator systems can thus be relatively large and heavy.

Furthermore, the bellows of such pressure compensator is exposed to the subsea environment, in particular to the seawater. This may cause corrosion problems for the bellows and may lead to the ingress of seawater into the enclosure of the subsea device upon failure of the bellows. Such seawater ingress may lead to a complete failure of the subsea device, e.g. due to short circuit currents or the like.

The document WO2010/034880A1 describes a pressure compensator that has a first bellows chamber that is surrounded by a second bellows chamber, the second bellows chamber forming a closed intermediate space around the first bellows chamber. A double barrier against the ingress of seawater is thus provided. In the disclosed configuration, the compensation capacity is determined by the size of the first bellows. The whole volume inside the first bellows chamber and in addition the volume inside the second bellows chamber are dead volumes, the liquid filling these volumes additionally requiring pressure compensation. In such configuration, the pressure compensator needs to have a significant size. Further an increase in the compensation capacity results in a significant increase in the dead volume, which in turn reduces the compensation capacity that is available for a subsea device (since the dead volume of liquid needs to be compensated).

It is desirable to provide a pressure compensator for use with a subsea device that can be manufactured easily and cost efficiently. It is further desirable that the pressure compensator is reliable during operation and has a long lifetime. It is desirable to reduce the size of pressure compensators, and to increase the utilization factor and compensation capacity. Also, it is desirable that the pressure compensator is protected from corrosion and provides protection against seawater ingress.

### Summary

Accordingly, there is a need to obviate at least some of the drawbacks mentioned above and to provide an improved pressure compensator for subsea use.

This need is met by the features of the independent claims. The dependent claims describe embodiments of the invention.

According to an embodiment of the invention, a pressure compensator for providing pressure compensation for a subsea device is provided. The pressure compensator comprises a compensator wall enclosing a compensation chamber and at least one bellows assembly. The bellows assembly comprises a metal bellows that forms part of the compensator wall. The metal bellows is deformable to change the inner volume of the compensation chamber. The bellows assembly further comprises an elastomeric bellows provided on the compensator wall and covering at least the metal bellows. The elastomeric bellows has a shape that is adapted to the shape of the metal bellows. A seal is further provided that seals the space between the metal bellows and the elastomeric bellows. The space between the metal bellows and the elastomeric bellows is provided with a vacuum (i.e. it is evacuated) so that a pressure applied by a medium to the compensator wall urges the elastomeric bellows into contact with the metal bellows.

When such pressure compensator is deployed subsea, the pressure may for example be applied to one side of the compensator wall by an ambient medium, in particular seawater and to the other side of the compensator wall by a compensation medium, in particular a liquid filling the compensation chamber.

By providing a vacuum between the metal bellows and the elastomeric bellows, a tight contact between the metal bellows and the elastomeric bellows may be ensured and the detection of an ingress of a medium, such as seawater, into the space between the metal bellows and the elastomeric bellows may be facilitated. Since the metal bellows is deformable, the material of which it is made may have a limited thickness, and may thus form a weak part of the pressure compensator. By providing the elastomeric bellows that covers the metal bellows, such part of the pressure compensator may be provided with a double barrier. Accordingly, if the metal bellows fails, e.g. due to fatigue, ingress of seawater into the compensation chamber may be prevented. Furthermore, the double barrier configuration is relatively compact, since the space between the metal bellows and the elastomeric bellows is evacuated, so that they are in direct contact and thus essentially act as a single bellows. A compact two barrier configuration can thus be achieved.

In an embodiment, the compensator wall comprises an outer wall having an outer side wall, which is preferably cylindrically shaped. The at least one bellows assembly may include at least an outer bellows assembly, the metal bellows of which forms part of the outer side wall.

The compensator wall may include a top dome closing one end of the cylindrical outer side wall. The outer side wall and/or the top dome may be made from metal.

The pressure compensator may further comprise a flow connection from the compensation chamber to a chamber of a subsea device. A compensation medium, such as a liquid, in particular a dielectric liquid filling the compensation chamber, may thus flow between the chamber of the subsea device and the compensation chamber. Accordingly, if the medium filling the chamber of the subsea device expands, e.g. due to heating, the additional volume of liquid may flow into the compensation chamber leading to an expansion of the bellows assembly, thereby compensating the volume increase. The flow connection may for example be provided by a duct, pipe, flow channel or an opening between the compensation chamber and the chamber of the subsea device.

In an embodiment, the compensator wall comprises an outer wall and an inner wall, and the compensation chamber is formed between the outer wall and the inner wall. The dead volume of the compensation chamber may thus be reduced. The pressure compensator may extend along a central axis (e.g. central axis of cylindrical side wall), and an outer wall may be defined as a wall that is further away from the central axis as the inner wall. The volume confined between the outer wall and the inner wall may constitute the compensation chamber.

The compensator wall may furthermore comprise an end wall to which the above mentioned outer wall is mounted. In embodiments in which an outer wall and an inner wall are provided, the end wall may for example have an annular or disc shape, and both the outer wall and the inner wall may be mounted to such annular or disc shaped end wall.

In an embodiment, the inner wall surrounds a first inner volume, the first inner volume being at least partially filled with an ambient medium. It may for example be at least partially filled with seawater when the pressure compensator is installed subsea. By providing a flow connection between the first inner volume and the ambient medium, so that the first inner volume may at least partially be filled with the ambient medium, the dead volume of the pressure compensator may be reduced, and the inner volume does not need to be pressure compensated.

The inner wall may for example have an inner surface facing the compensation chamber and being in contact with the compensation medium filling the compensation chamber, and an outer surface that is in contact with the ambient medium. In this regard, inner surface and outer surface define their positioning with respect to the compensation chamber, i.e. inside the compensation chamber or outside the compensation chamber.

In an embodiment, the inner wall may comprise a cylindrical inner side wall and an inner top dome closing one end of the inner cylindrical side wall. The compensator wall may for example comprise the outer side wall and outer top dome and the inner side wall and inner top dome confining the compensation volume. Such configuration may achieve a pressure compensator having a relatively small dead volume.

The at least one bellows assembly may comprise at least an inner bellows assembly, the metal bellows of which forms part of the inner wall, in particular the inner side wall. In such configuration, the outer wall may protect the inner bellows assembly. In other embodiments, the inner wall may be a rigid inner wall that does substantially not deform during operation of the pressure compensator, i.e. it may not comprise any bellows or bellows portion.

In some embodiments, both an outer bellows assembly and an inner bellows assembly may be provided. The outer bellows assembly and the inner bellows assembly may be configured similarly, i.e. each may comprise a metal bellows and an elastomeric bellows, the space between which is evacuated.

In an embodiment, the compensator wall, the compensation chamber and the at least one bellows assembly form a first compensator assembly. The pressure compensator may further comprise at least a second compensator assembly that is arranged in a volume surrounded by an inner wall of the first compensator assembly. Furthermore, a flow connection may be provided between the compensation chambers of the first compensator assembly and the at least one second compensator assembly. A pressure compensator having an increased compensation capacity may thus be achieved, while the dead volume of the pressure compensator may be kept low. Further compensator assemblies may be provided, for example inside a second inner volume surrounded by an inner wall of the second compensator assembly.

In an embodiment, the pressure compensator further comprises a leak detector configured to detect ingress of a medium, such as an ambient medium or a compensation medium, into the space between the metal bellows and the elastomeric bellows. By providing such leak detector, the failure or leakage of the metal bellows or the elastomeric bellows may be detected reliably. Accordingly, if one of these bellows should fail, the pressure compensator still remains operable, and an indication is received that the pressure compensator may need to be serviced or substituted in the near future. A reliable and continued operation of the subsea device for which the pressure compensator provides pressure compensation may thus be achieved.

The leak detector may be implemented in several ways. As an example, the leak detector may comprise a pressure gauge for detecting a pressure in the space between the metal bellows and the elastomeric bellows of the bellows assembly. In another implementation, the leak detector may comprise a resistance or conductance measuring device for measuring resistance or conductance in the space between the metal bellows and the elastomeric bellows. By such measuring device, it may also be differentiated between an ingress of ambient medium or of compensation medium, since for example seawater as a different conductivity compared to dielectric liquid which may be used as compensation medium.

In an embodiment, the metal bellows has an inner surface towards the compensation chamber and an outer surface towards an ambient medium. The elastomeric bellows may be provided on the inner surface of the metal bellows or on the outer surface of the metal bellows. Accordingly, depending on the intended application, either the elastomeric bellows or the metal bellows may be in contact with ambient medium, in particular seawater, when the pressure compensator is deployed subsea. Exposing the elastomeric bellows to the ambient medium may have the advantage that the metal bellows is protected from corrosion. Exposing the metal bellows to the ambient medium may have the advantage that diffusion of ambient medium through the elastomeric bellows may be prevented.

The metal bellows may have a corrugated portion providing flexibility for contraction and expansion of the metal bellows. In particular, the metal bellows may only consist of such corrugated portion, i.e. the metal bellows may be defined as a corrugated portion of the compensator wall. The elastomeric bellows may at least cover such corrugated portion of the compensator wall, i.e. the metal bellows. Accordingly, since the corrugated portion of the metal bellows may more easily fail than other parts of the compensator wall, the durability and life time of the pressure compensator may be improved by protecting the corrugated portion with the elastomeric bellows.

In an embodiment, the elastomeric bellows is part of an elastomeric wall covering at least part of the compensator wall. The compensator wall may for example comprise an outer wall, and the elastomeric wall may cover the outer wall completely. In other embodiments, the compensator wall may comprise an inner wall including the metal bellows, and the elastomeric wall may completely cover the inner wall, partially or completely.

For this purpose, the elastomeric wall may for example include a cylindrical wall section which comprises the elastomeric bellows and a top dome, that is shaped similar to the outer top dome or the inner top dome, depending on where the elastomeric wall is provided. If the outer wall or the inner wall does not comprise a metal bellows, an elastomeric wall for covering such outer wall or inner wall may not be provided. In such case, the outer wall or inner wall may be provided with sufficient thickness and of suitable non corrosive material so as to avoid the need for a double barrier.

In an embodiment, the compensator wall includes an outer wall having a flange and the elastomeric wall may be sealed at the flange to the outer wall. A similar configuration may be provided for the inner wall. By means of such flange, the outer wall (or the inner wall) may for example be mounted to an end wall, such as a disk shaped or annular end wall.

In an embodiment, the seal that seals the space between the metal bellows and the elastomeric bellows may be provided by means of a flange connection, a vulcanization of elastomeric material to the compensator wall or by a combination thereof. The seal may be provided a distance away from the elastomeric bellows and the metal bellows, for example at the above mentioned flange.

In an embodiment in which the elastomeric bellows is part of an elastomeric wall that completely covers for example an outer wall or an inner wall, the seal may be a flange seal between the elastomeric wall and the outer/inner wall. Thus, the seal may comprise single or double sealing around the flange, for example by extending the elastomeric wall around the flange and providing a compression, for example compressing the elastomeric wall between the flange and an end wall.

The length of the perimeter of the metal bellows in a direction parallel to the direction of expansion and contraction may be substantially similar to the length of the perimeter of the elastomeric bellows in the same direction. In such configuration, a stretching of the elastomeric material by which the elastomeric bellows is formed may be reduced or may even be prevented, when mounted to the metal bellows.

The pressure compensator may furthermore comprise a protection cover for protecting the compensator wall. Furthermore, it may comprise a stop for the expansion and/or contraction of the bellows assembly. Further compression/expansion stops may be provided for further bellows assemblies.

In some configurations, an inner wall or an outer wall of the compensator wall may comprise one or more bellows assemblies, for example two or more bellows assemblies.

According to a further embodiment of the invention, a method of manufacturing a pressure compensator for providing pressure compensation for a subsea device is provided. The method comprises the steps of providing an outer wall enclosing a compensation chamber; providing at least one bellows assembly comprising a metal bellows forming part of the compensator wall, the metal bellows being deformable to change the inner volume of the compensation chamber, and an elastomeric bellows provided on the compensator wall and covering at least the metal bellows, wherein the elastomeric bellows has a shape that is adapted to the shape of the metal bellows; sealing the space between the metal bellows and the elastomeric bellows; and evacuating the space between the metal bellows and the elastomeric bellows such that a pressure applied by a medium to the compensator wall urges the elastomeric bellows into contact with the metal bellows.

By such method, a pressure compensator having advantages similar to the ones outlined further above may be achieved.

In an embodiment, the method may further comprise the step of leak testing the sealed space between the metal bellows and the elastomeric bellows. By such leak testing, it may be ensured that the space is securely sealed and that the pressure compensator remains operational for a significant amount of time.

In an embodiment, the space may be evacuated through an opening, and after the pressure has dropped below a threshold value, the opening may be sealed. Prior to sealing, the above mentioned pressure testing may be performed. The threshold value may for example be a value that is smaller than 10⁻¹ mbar, 10⁻² mbar or even 10⁻³ mbar.

It is to be understood that the features mentioned above and those yet to be explained below can be used not only in the respective combinations indicated, but also in other combinations or in isolation without living the scope of the present invention. In particular, the method may be performed so as to obtain a pressure compensator in any of the above outlined configurations. Furthermore, the above described pressure compensator may be configured as described with respect to the method.

### Brief description of the drawings

The foregoing and other features and advantages of the invention will become further apparent from the following detailed description read in conjunction with the accompanying drawings. In the drawings, like reference numerals refer to like elements.
Figure 1 is a schematic drawing showing a sectional side view of a pressure compensator for a subsea device according to an embodiment of the invention.
Figure 2 is a schematic drawing showing a side view of a pressure compensator according to an embodiment of the invention.
Figure 3 is a schematic drawing showing a top view of the pressure compensator of Figure 2.
Figure 4 is a schematic drawing showing a perspective view of the pressure compensator of Figure 2.
Figures 5A and 5B are schematic drawings showing a sectional view of the pressure compensator of Figure 2.
Figure 6 is a schematic drawing showing a perspective view of a pressure compensator according to a further embodiment of the invention.
Figure 7 is a schematic drawing showing a sectional side view of a pressure compensator according to a further embodiment of the invention.

### Detailed description

In the following, embodiments of the invention are described in detail with reference to the accompanying drawings. It is to be understood that the following description of the embodiments is given only for the purpose of illustration and is not to be taken in a limiting sense. It should be noted, that the drawings are to be regarded as being schematic representations only, and elements in the drawings are not necessarily to scale with each other. Rather, the representation of the various elements is chosen such that their function and general purpose become apparent to a person skilled in the art.

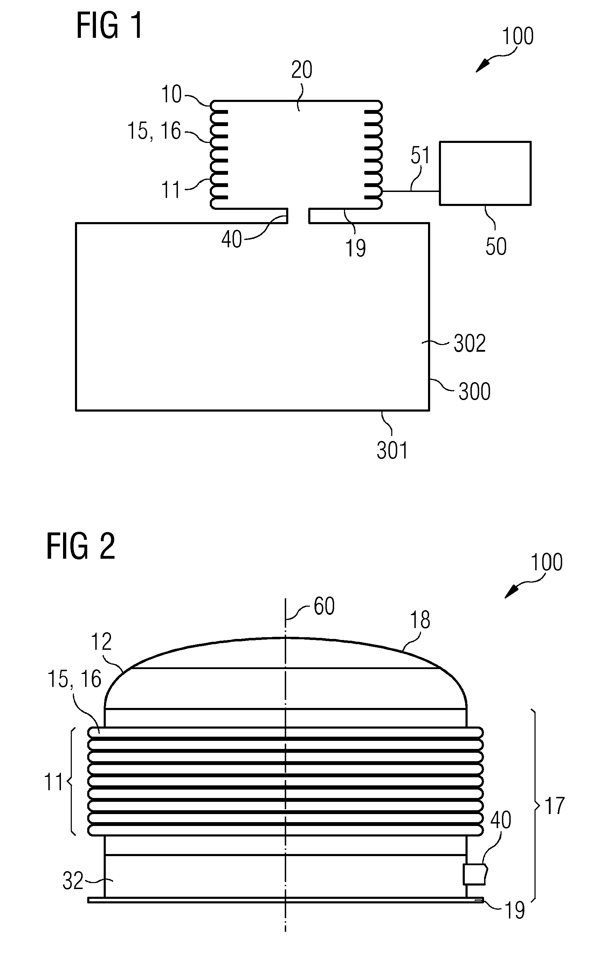

Figure 1 schematically illustrates a subsea device 300 having a subsea enclosure 301 which encloses a chamber 302. Subsea device 300 may for example be a subsea transformer, a subsea converter, in particular a subsea variable speed drive, a subsea switchgear, a subsea motor, a subsea control and/or communication module or the like. Accordingly, respective mechanical, electric and/or electronic components may be disposed in the chamber 302. Chamber 302 is pressure compensated by means of pressure compensator 100. It should be clear that subsea device 300 may comprise one or more pressure compensated chambers, and may additionally comprise one or more chambers in which a predetermined pressure is maintained (pressure resistant chambers), for example a close to atmospheric pressure (e.g. below 10 bar or 5 bar, e.g. about 1.5 bar). Accordingly, some components which may not be operable under the high subsea pressures may be placed in a pressure resistant enclosure inside the chamber 302, or adjacent thereto, or the like.

Figure 1 illustrates an embodiment of a pressure compensator 100 for compensating volume variations of a liquid filling the chamber 302 of subsea device 300 and for balancing the pressure inside the chamber 302 to a pressure prevailing in an ambient medium, for example in seawater when subsea device 300 is installed subsea. The pressure compensator 100 includes a compensator wall 10 which encloses a compensation chamber 20. A flow connection 40 is provided between the compensation chamber 20 and the chamber 302 of the subsea device to allow an exchange of fluid. The compensation chamber 20 is preferably filled with the compensation medium, in particular with a liquid, such as a dielectric liquid. Examples of such liquid include oil, or a synthetic ester based liquid, such as Midel.

The pressure compensator 100 has a bellows assembly 11 that includes a metal bellows 15 and an elastomeric bellows 16. The metal bellows 15 forms part of the compensator wall 10. The metal bellows 15 may be constituted by or consist of a corrugated part of the compensator wall 10. The elastomeric bellows 16 covers at least this corrugated part of compensator wall 10, i.e. it covers at least the metal bellows 15. The elastomeric bellows 16 may be provided on an outer surface of the metal bellows 15, i.e. on a surface facing the ambient medium, such as seawater, or it may be provided on an inner surface of the metal bellows 15, i.e. on a surface that faces the compensation chamber 20, in particular the compensation medium therein. Either the metal bellows 15 or the elastomeric bellows 16 may thus be exposed to surrounding seawater when installed subsea.

In the embodiment of Figure 1, the compensator wall 10 has a cylindrical side wall section which almost entirely consists of the bellows assembly 11. In other embodiments, such side wall section may further comprise non-deformable sections, e.g. cylindrical sections without corrugation. In the example of Figure 1, the compensator wall 10 further comprises an upper end wall and a lower end wall 19. The end walls and the cylindrical side wall define the compensation chamber 20.

The space between the metal bellows 15 and the elastomeric bellows 16 is sealed by a seal. Accordingly, no medium can enter the space between the bellows 15, 16. The space between the bellows 15, 16 is further evacuated, so that no medium is present between these bellows. Accordingly, the elastomeric bellows 16 sits closely on the metal bellows 15. Due to the vacuum and the elasticity of the elastomeric bellows 16, the elastomeric bellows 16 is pushed against the metal bellows 15 by the ambient pressure. Accordingly, in the schematic drawing of figure 1, the elastomeric bellows 16 and the metal bellows 15 are shown as a single bellows.

Due to the pressure compensation capabilities of pressure compensator 100, the pressure inside chamber 20 is substantially similar to the pressure in the outside environment, so that substantially the same pressure acts from both sides on the bellows 15, 16 and urges them into contact.

As can be seen, such configuration provides a double barrier protection for at least the corrugated part of the compensator wall 10. If the elastomeric bellows 16 is provided on the outside in contact with seawater, the metallic bellows 15 can be protected from the corrosive subsea environment. Furthermore, if one of the bellows 15, 16 fails, for example due to a leak, the other bellows still prevents the ingress of ambient medium, in particular seawater into the compensation chamber 20. Reliability of the pressure compensator 100 can thus be increased. Furthermore, since the space between the bellows 15, 16 is evacuated, the additional barrier does not require additional space. Also, no additional dead volume is generated by the additional barrier. Pressure compensator 100 is thus relatively compact and has a relatively small dead volume compared to conventional two-barrier solutions.

Pressure compensator 100 may furthermore comprise a leak detector 50 which detects a leakage in one of the bellows 15, 16. Leak detector 50 employs a sensor for detecting whether any compensation medium from the chamber 20 or any ambient medium such as seawater enters the space between the metal and elastomeric bellows 15, 16. As an example, leak detector 50 may employ a pressure sensor or pressure gauge to detect a change in pressure in the space between the bellows 15, 16. Leak detector 50 may also additionally or alternatively employ a sensor for measuring conductivity or resistance within the space between the bellows 15, 16. Such sensor may for example comprise two or more electrodes (e.g. conductor plates) that are disposed in the space between the bellows 15, 16 and that are electrically isolated from the metal bellows 15. If seawater enters the space, the resistance between such spaced apart conductor plates will change. The change will be different from a situation in which compensation medium, in particular a dielectric liquid enters the space, which generally has a lower conductivity. Accordingly, by such type of sensor, it may even be determined whether the bellows that is in contact with the compensation medium or that is in contact with the ambient medium has leaked.

Leak detector 50 may comprises a connection 51 to the respective sensor element.

In operation, the bellows 15, 16 of the bellows assembly 11 will expand and/or contract upon a change of the volume of the liquid filling the chamber 302 and the compensation chamber 20. A difference between the outside pressure and the pressure prevailing in chambers 20, 302 is balanced by a corresponding expansion or contraction of the bellows assembly 11. In some embodiments, the pressure compensator 100 may be biased, for example to generate a small overpressure within the chamber 302 of the subsea device 300. This way, the ingress of seawater upon leakage may be prevented, and such leakage may furthermore be detected by a drift in the pressure compensator when compensation medium is leaking out. The biasing may for example be generated by adding weight to the upper end wall of the compensator wall 10, by respective spring assemblies or the like.

Figure 2 shows a side view of a particular implementation of the pressure compensator 100, so that the above explanations are equally applicable to the pressure compensator 100 of figure 2. Pressure compensator 100 has a compensator wall that includes the outer wall 12. Outer wall 12 has a cylindrically shaped outer side wall 17 and an outer top dome 18. The central axis 60 of the outer side wall 17 is further indicated.

The compensator wall 10 further includes the end wall 19. Outer side wall 17 includes the bellows assembly 11 comprising the metal and elastomeric bellows 15, 16. In the example of figure 2, the elastomeric bellows 16 is provided on the outer surface of the outer wall 12, and is thus in contact with seawater when pressure compensator 100 is deployed subsea. The outer wall 12 is made of metal and includes the metal bellows 15. The elastomeric bellows 16 forms part of an outer elastomeric wall 32, which in the example of figure 2 completely covers the metallic outer wall 12. As outlined above, in some embodiments, only part of the outer wall 12 may be covered by elastomeric material. The flow connection 40 is provided on the side wall 17.

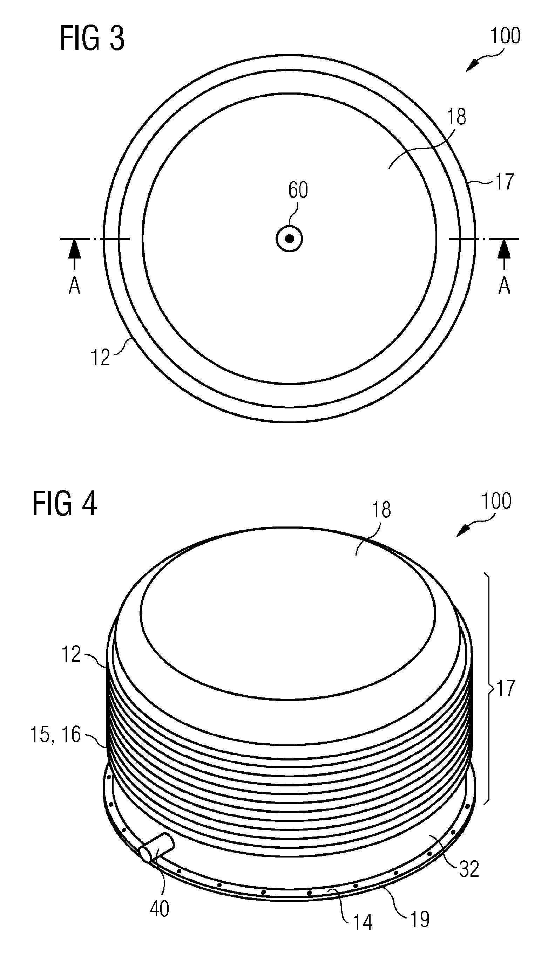

Figure 3 is a top view of the pressure compensator 100 of figure 2. As can be seen, the pressure compensator 100 has a cylindrical shape around the central axis 60.

The side wall 17 extends circumferentially around the central axis 16, which is a symmetry axis of the pressure compensator 100. In operation, the top dome 18 moves in the direction of the central axis 60 upon compression and expansion of the bellows assembly 11. At the end wall 19, the pressure compensator 100 may be fixed to the subsea device 300.

Figure 4 shows the pressure compensator 100 of figure 2 in a perspective view. As can be seen, the side wall 17 comprises a cylindrical section without corrugation in which the flow connection 40 is provided. The outer wall 12 further comprises a flange 14 which is mounted to a corresponding flange of the end wall 19. The outer elastomeric wall 32 can for example be folded around a flange 14 and compressed between the flange of the end wall 19 and the flange 14 of outer wall 12. This way, the seal may be formed that seals the space between the elastomeric bellows 16 and the metal bellows 15. In such configuration, in which the elastomeric wall 32 covers the outer wall 12 completely, the seal on flange 14 may be sufficient to completely seal the space between the outer elastomeric wall 32 and the outer metal wall 12. Accordingly, by means of the above mentioned leak detector 50, any leak in the outer elastomeric wall 32 or the outer metal wall 12 may be detected. An efficient and compact double barrier against seawater ingress as well as an effective leak detection may thus be provided.

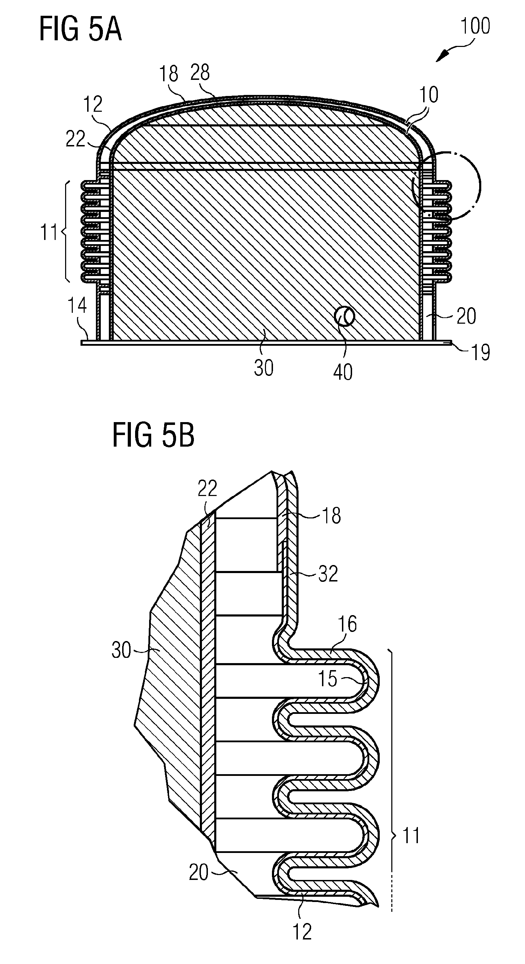

Figure 5A shows a sectional side view of pressure compensator 100 taken along the line A-A shown in figure 3. As illustrated in figure 5A, the pressure compensator 100 further comprises an inner wall 22. In the present embodiment, inner wall 22 comprises a cylindrical inner wall section without corrugations, that is a rigid wall section and that does not deform during operation of pressure compensator 100. It furthermore comprises an inner top dome 28 closing one end of the cylindrical inner side wall 22. The other end of the inner cylindrical side wall 22 may be open or it may be closed by a further end wall and provided with an opening, so that ambient medium can flow into the volume 30 that is surrounded by the inner wall 22.

The end wall 19 may have an annular shape that provides a connection between the inner wall 22 and the outer wall 12. In other embodiments, it may have a disk shape thus also enclosing the inner volume 30, and an opening may be provided in the end wall 19 to allow ambient medium to flow into the inner volume 30. The compensator wall 10 may thus comprise the inner wall 22, the outer wall 12 and the end wall 19. The compensation chamber 20 is confined between the inner wall 22 and the outer wall 12. In such configuration, the dead volume of pressure compensator 100 can be further reduced, since only the compensation chamber 20 confined between inner wall 22 and outer wall 12 is filled with compensation medium. As shown in figure 5A, this volume can be relatively small. In operation, upon an expansion of the liquid filling chamber 302 of subsea device 300, the bellows assembly 11 will expand, thus providing increased separation between outer top dome 18 and inner top dome 28, thus leading to a significant volume increase of compensation chamber 20. Pressure compensator 100 thus provides a relatively large compensation capacity, while the dead volume is relatively small. The flow connection 40 leads into the compensation chamber 20.

In some embodiments, the inner wall 22, in particular the cylindrical inner side wall, may comprise the bellows assembly 11, and the outer cylindrical side wall 17 may be a rigid wall without corrugations. In other embodiments, a bellows assembly 11 may be provided both on the outer wall 12 and the inner wall 22, as will be described further below.

Figure 5B is a schematic drawing showing an enlarged representation of the portion that is encircled in figure 5A. As can be seen, the elastomeric bellows 16 is provided outside on the metal bellows 15. Due to the evacuation of the space there between, bellows 16 sits closely on bellows 15. Bellows 15 and 16 thus substantially act as a single bellows.

Furthermore, due to the required flexibility of metal bellows 15, it may be provided with a smaller wall thickness compared to other parts of the compensator wall 10. As illustrated, the metal bellows 15 may for example be mounted, in particular welded or soldered to the outer dome 18 having a larger wall thickness. Accordingly, the protection by the elastomeric bellows 16 is particular beneficial for the metal bellows 15. As can be seen, the elastomeric outer wall 32 extends also over the remaining parts of the outer wall 12, in particular also over the top dome 18. The inner wall 22 can be a relatively thick metal wall, so that even though it is in contact with ambient medium present inside the inner volume 30, the inner wall 22 may be sufficient to protect the compensation chamber 20 against seawater ingress. In other embodiments, the inner wall 22 may be provided with the corresponding elastomeric wall 32. In embodiments in which inner wall 22 comprises a metal bellows, a respective elastomeric bellows 15 is provided, or an elastomeric wall (similar to 32) completely covering the inner wall 22 may be provided.

Elastomeric wall 32 may be made as a single part, or may be composed of different wall parts, which may be adhered to one another by molding techniques, adhesive, vulcanization or the like. Furthermore, the skilling of the space between the metal bellows 15 and the elastomeric bellows 16 may be achieved by different means. As an example, a portion of the elastomeric bellows 16 or of the elastomeric wall 32 may be vulcanized to the metal bellows 15 or the respective compensator wall, in particular the outer wall 12 or the inner wall 22. An effective sealing may thus be achieved, in particular for configurations for which the elastomeric wall 32 does not completely cover the outer wall 12 or the inner wall 22.

The shape of the elastomeric bellows 16 may be adapted to the shape of the metal bellows 15. This way, the elastomeric bellows 16 is not overly stretched or compressed when being brought into tight contact with metal bellows 15 due to the evacuation of the space there between. This may ensure long lifetime and reliable operation of the elastomeric bellows 16. In particular, the length of a line on the surface of metal bellows 15 that is in contact with the elastomeric bellows 16 taken perpendicularly to the corrugations may be substantially the same as a corresponding line on the surface of the elastomeric bellows 16 that is in contact with the metal bellows 15 taken perpendicularly to the corrugations. Stretching of the elastomeric bellows 16 may thus be prevented.

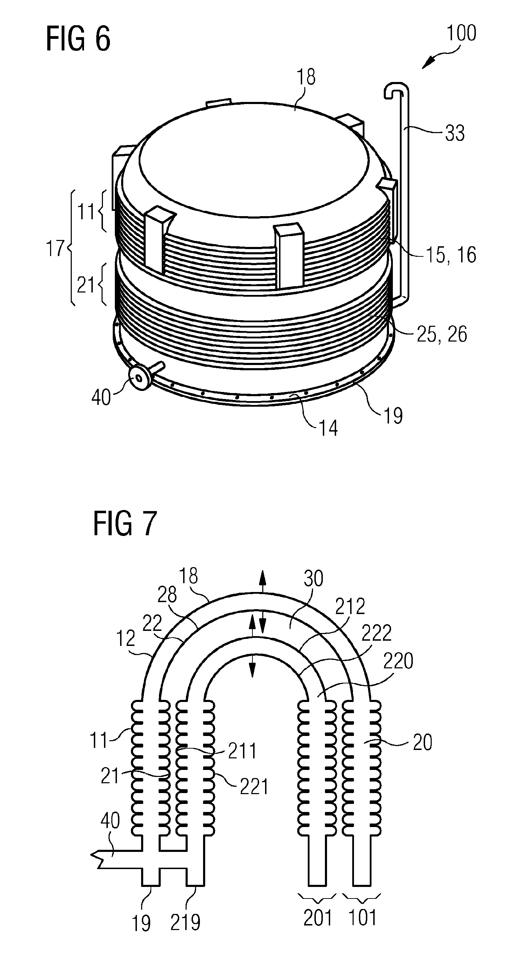

Figure 6 is a schematic drawing showing a perspective view of a further embodiment of the pressure compensator 100. The embodiment of figure 6 is a modification of the embodiment of figure 2, so that the explanations given above are equally applicable. In the example of figure 6, the compensator wall comprises two bellows assemblies 11, 21. The outer side wall 17 includes these two bellows assemblies 11, 21 and furthermore includes a cylindrical section without corrugations there between. Again, part of the end wall 19 and the flange 14 are visible. To protect the bellows assemblies 11, 21, the pressure compensator 100 may be provided with a protection cover. Furthermore, expansion stops and/or compression stops may be provided to prevent excessive expansion/compression of the bellows assemblies 11, 21. The bellows assembly 21 may be configured similar to the bellows assembly 11, i.e. as outlined further above.

The pressure compensator 100 of figure 6 further includes a vent pipe 33. Pressure compensator 100 also comprises an inner wall 22 surrounding an inner volume 30 that is flow communication with ambient medium. The vent pipe 33 leads into this inner volume 30. Accordingly, when the pressure compensator 100 is deployed subsea, and air is trapped inside the inner volume 30, it may be vented via the vent pipe 33.

Figure 7 is a schematic drawing showing a further embodiment of the pressure compensator 100. The embodiment of figure 7 is a modification of the embodiment shown in figure 2, so that the above explanations are equally applicable. The sectional side view of figure 7 shows a first compensator assembly 101 which comprises the outer wall 12 and the inner wall 22. As explained with respect to figure 5, the inner wall 22 may comprise a second bellows assembly 21. The first bellows assembly 11 and the second bellows assembly 21 may be configured as described above. Furthermore, as mentioned above, the outer wall 12 and the inner wall 22 may both be covered, completely or partially, by an elastomeric wall 32. In operation, upon an increase of the volume of the liquid filling the chamber 302, the additional volume is taken up by expansion of the first bellows assembly 11 and contraction of the second bellows assembly 21. The top dome 18 thus moves upward and the inner top dome 28 moves downward, as illustrated by arrows, thus increasing the volume of the compensation chamber 20 for taking up the additional volume of the compensation liquid.

Compensation chamber 20 is further closed by the end wall 19, which may have an annular shape, and flow connection 40 provides fluid communication between the compensation chamber 20 and the chamber 302 of the subsea device.

In the embodiment of figure 7, the pressure compensator 100 comprises a further second compensator assembly 201, which is configured substantially similar to the first compensator assembly 101. The second compensator assembly 201 is arranged within the inner volume 30 that is surrounded by the inner wall 22. The second compensator assembly 201 comprises an outer wall 212, an inner wall 222 and an end wall 219, which form part of a second compensator wall. Outer wall 212, inner wall 222 and end wall 219 enclose a second compensation chamber 220. The second compensation chamber 220 is in flow communication with chamber 302 of the subsea device via the flow connection 40. Similar to the walls 12 and 22, the second outer wall 212 comprises a first bellows assembly 211 and the second inner wall 220 comprises a second bellows assembly 221. These bellows assemblies 211, 221 can be configured similar to the bellows assemblies 11, 21, they may in particular comprise a metal bellows 15 and an elastomeric bellows 16.

By such second compensator assembly 201, the space available in the inner volume 30 may be efficiently used to further increase the compensation capacity of the pressure compensator 100. In particular, by contraction/expansion of the bellows assemblies 211, 221, the volume of the second compensation chamber 220 can be changed, thus accommodating volume changes of the liquid filling chamber 302. It should be clear that further compensator assemblies 101, 201 may be provided to further increase the compensation capacity of pressure compensator 100, for example within the volume surrounded by second inner wall 222.

The end walls 19, 219 may be provided as a common end wall, for example in form of a disk-shaped end wall or an end wall having two concentric rings. In other configurations, they may be provided separately.

It should be clear that the features of the embodiments described above can be combined with each other unless noted to the contrary. As an example, one or more of the walls 11, 21, 211, 221 may be provided as a rigid wall without corrugations. In another example, the pressure compensator of figures 2 to 5 may comprise a second compensator assembly inside the inner volume 30 that is configured similar to the first compensator assembly illustrated in figure 5A.

Also, some embodiments may comprise two or more bellows assemblies on an outer side wall and/or an inner side wall.

An embodiment of the invention further provides a method of manufacturing a pressure compensator having any of the above outlined configurations. In the method, the elastomeric bellows or wall is sealed to the outer wall or inner wall. After sealing, the space between the elastomeric bellows or elastomeric wall and the metal bellows or inner/outer wall is evacuated. This may be achieved by using a vacuum pump and a flow connection into said space. The method may comprise, after evacuation, the performing of a leak test in order to ensure that there is no leakage into the space, for example via the seal, via the elastomeric wall, or via the inner/outer wall. Such leakage test may for example be performed by means of a helium sniffer. After it has been ensured that no leak is present, the flow connection to the space between the metal bellows and the elastomeric bellows can be closed, for example by vulcanization of the elastomeric material or the like. In other embodiments, a leak detector for subsea use (as outlined above) may be attached to such fluid flow connection into that space. In other embodiments, an electric connection may be provided into the space for contacting a sensor disposed in the space.

The metal bellows may be made of a metal material, such as alloy 625, in particular Inconel 625. The elastomeric bellows may for example be made of a rubber material, such as natural rubber.

The pressure compensator 100 may be adapted to be operable in a subsea environment. In particular, it may be operable at a water depth of at least 1,000 m preferably at least 2,000 or even at least 3,000m. A reliable and compact pressure compensator having a relatively small dead volume, a relatively large compensation capacity, and an efficient protection against seawater ingress may thus be provided for the subsea device 300.

While specific embodiments are disclosed herein, various changes and modifications can be made without departing from the scope of the invention. The present embodiments are to be considered in all respects as illustrative and non-restrictive, and all changes coming within the meaning and equivalency range of the appended claims are intended to be embraced therein.

## Claims

1. A pressure compensator for providing pressure compensation for a subsea device, comprising:
- a compensator wall (10) enclosing a compensation chamber (20),
- at least one bellows assembly (11) comprising a metal bellows (15) forming part of the compensator wall (10), the metal bellows (15) being deformable to change the inner volume of the compensation chamber (20), and an elastomeric bellows (16) provided on the compensator wall (10) and covering at least the metal bellows (15), wherein the elastomeric bellows (16) has a shape that is adapted to the shape of the metal bellows (15),
- a seal sealing the space between the metal bellows (15) and the elastomeric bellows (16),
wherein said space between the metal bellows (15) and the elastomeric bellows (16) is provided with a vacuum so that a pressure applied by a medium to the compensator wall (10) urges the elastomeric bellows (16) into contact with the metal bellows (15).

2. The pressure compensator according to claim 1, wherein the compensator wall (10) comprises an outer wall (12) having a cylindrically shaped outer side wall (17), wherein the at least one bellows assembly (11) includes at least an outer bellows assembly, the metal bellows (15) of which forms part of said outer side wall (17).

3. The pressure compensator according to claim 2, wherein the compensator wall (10) includes a top dome (18) closing one end of the cylindrical outer side wall (17).

4. The pressure compensator according to any of the preceding claims, wherein the compensator wall (10) comprises an outer wall (12) and an inner wall (22), the compensation chamber (20) being formed between the outer wall (12) and the inner wall (22).

5. The pressure compensator according to claim 4, wherein the inner wall (22) surrounds a first inner volume (30), the first inner volume (30) being at least partially filled with an ambient medium, in particular with seawater when the pressure compensator is installed subsea.

6. The pressure compensator according to claim 4 or 5, wherein the inner wall (22) comprises a cylindrical inner side wall and an inner top dome (28) closing one end of the inner cylindrical side wall.

7. The pressure compensator according to any of claims 4-6, wherein the at least one bellows assembly comprises at least an inner bellows assembly (22), the metal bellows (15) of which forms part of the inner wall (22).

8. The pressure compensator according to any of the preceding claims, wherein the compensator wall (10), the compensation chamber (20) and the at least one bellows assembly (11) form a first compensator assembly (101),
wherein the pressure compensator (100) further comprises:
- at least one second compensator assembly (201) arranged in a volume (30) surrounded by an inner wall (22) of the first compensator assembly (101),
- a flow connection between the compensation chambers (20, 220) of the first compensator assembly (101) and the at least one second compensator assembly (201).

9. The pressure compensator according to any of the preceding claims, further comprising a leak detector (50) configured to detect ingress of a medium into the space between the metal bellows (15) and the elastomeric bellows (16).

10. The pressure compensator according to any of the preceding claims, wherein the metal bellows (15) has an inner surface towards the compensation chamber (20) and an outer surface towards an ambient medium, wherein the elastomeric bellows (16) is provided on the inner surface of the metal bellows or on the outer surface of the metal bellows.

11. The pressure compensator according to any of the preceding claims, wherein the metal bellows (15) has a corrugated portion providing flexibility for contraction and expansion of the metal bellows, wherein the elastomeric bellows (16) covers at least said corrugated portion of the metal bellows (15).

12. The pressure compensator according to any of the preceding claims, wherein the elastomeric bellows (16) is part of an elastomeric wall (32) covering at least part of the compensator wall (10), preferably an outer wall (12) of the compensator wall (10).

13. The pressure compensator according to claim 12, wherein the compensator wall (10) includes an outer wall (12) having a flange (14), wherein the elastomeric wall (32) is sealed at the flange (14) to the outer wall (10).

14. The pressure compensator according to any of the preceding claims, wherein the seal that seals the space between the metal bellows (15) and the elastomeric bellows (16) is provided by means of a flange connection, a vulcanization of elastomeric material to the compensator wall or by a combination thereof.

15. A method of manufacturing a pressure compensator for providing pressure compensation for a subsea device (300), comprising the steps of:
- providing a compensator wall (10) enclosing a compensation chamber (20),
- providing at least one bellows assembly (11) comprising a metal bellows (15) forming part of the compensator wall (10), the metal bellows (15) being deformable to change the inner volume of the compensation chamber (20), and an elastomeric bellows (16) provided on the compensator wall (10) and covering at least the metal bellows (15), wherein the elastomeric bellows (16) has a shape that is adapted to the shape of the metal bellows (15),
- sealing the space between the metal bellows (15) and the elastomeric bellows (16), and
- evacuating the space between the metal bellows (15) and the elastomeric bellows (16) such that a pressure applied by a medium to the compensator wall (10) urges the elastomeric bellows (16) into contact with the metal bellows (15).
